Europäisches Patentamt

European Patent Office

Office européen des brevets

(19)

(11) Publication number: **0 467 352 A2**

# EUROPEAN PATENT APPLICATION

(12)

(21) Application number: **91111986.5**

(22) Date of filing: **17.07.91**

(51) Int. Cl.⁵: **H03K 3/027**, H03K 3/353, H03K 19/0175

(30) Priority: **19.07.90 IT 2098890**

(43) Date of publication of application:
**22.01.92 Bulletin 92/04**

(84) Designated Contracting States:
**DE FR GB IT SE**

(71) Applicant: SGS-THOMSON
MICROELECTRONICS s.r.l.
Via C. Olivetti, 2

I-20041 Agrate Brianza Milano(IT)

(72) Inventor: **Elia, Salvatore**
**Viale Romagna 39**
**I-20092 Cinisello Balsamo, Milano(IT)**

(74) Representative: **Modiano, Guido et al**
**MODIANO, JOSIF, PISANTY & STAUB**
**Modiano & Associati Via Meravigli, 16**
**I-20123 Milano(IT)**

(54) Multi-compatible input stage particularly for logic gates in integrated circuits.

(57) The multi-compatible input stage particularly for logic gates in integrated circuits comprises a first inverting logic gate, which constitutes a TTL-compatible stage and has its input terminal connected to a signal in input to the input stage. The first inverting logic gate has its output terminal connected to the input terminal of a second inverting logic gate and to the output terminal of a third inverting logic gate. The second inverting logic gate has its output terminal connected to the input terminal of the third inverting logic gate and to the output terminal of the input stage. The above described inverting gates constitute a toggle circuit or Schmitt trigger. A first terminal and a second terminal are provided for selection signals of the third inverting logic gate.

FIG. 4

The present invention relates to a multi-compatible input stage particularly for logic gates in integrated circuits.

In the integrated circuits which are currently manufactured and used to produce complex circuits, there is a technical problem related to the compatibility of said integrated circuits with the different types of integrated or non-integrated circuitry used in said complex circuits.

Two basic compatibility types are usually provided: TTL (Transistor Transistor Logic) compatible input, or inputs with high noise immunity, typically provided by means of toggle circuits or Schmitt triggers, the operation whereof is explained hereinafter.

These two types of input are currently provided in integrated circuits with usually complicated executions, and the two compatibilities are usually not provided in common, thus constituting two different families of components defined by their own typical input compatibility. If instead both basic compatibilities are provided, the solutions which are currently used entail, as explained in greater detail hereinafter, a great waste of silicon surface of the substrate or wafer used for the integrated circuit itself, due to the complexity of the solutions employed.

The aim of the present invention is to eliminate or substantially reduce the disadvantages described above in known types of input stage for integrated circuits by providing a multi-compatible input stage particularly for logic gates in integrated circuits which substantially reduces the complexity of execution of said input stages.

Within the scope of the above aim, an object of the present invention is to provide a multi-compatible input stage which substantially reduces the surface of the silicon wafer required to produce it.

Another object of the present invention is to provide a multi-compatible input stage which can be easily integrated on electronic circuits, is relatively easy to manufacture and at competitive costs.

This aim, these objects and others which will become apparent hereinafter are achieved by a multi-compatible input stage particularly for logic gates in integrated circuits according to the invention, as defined in the accompanying claims.

Further characteristics and advantages of the invention will become apparent from the description of a preferred but not exclusive embodiment of a multi-compatible input stage particularly for logic gates in integrated circuits according to the invention, illustrated only by way of non-limitative example in the accompanying drawings, wherein:

figures 1a, 1b and 1c are diagrams of the operation of a Schmitt trigger;

figure 2 is a circuit diagram of a known type used in CMOS technology to provide a Schmitt trigger;

figure 3 is a circuit diagram of a known type used in CMOS technology to provide a TTL-compatible gate and a Schmitt trigger; and

figure 4 is a conceptual diagram of a multi-compatible input stage according to the invention.

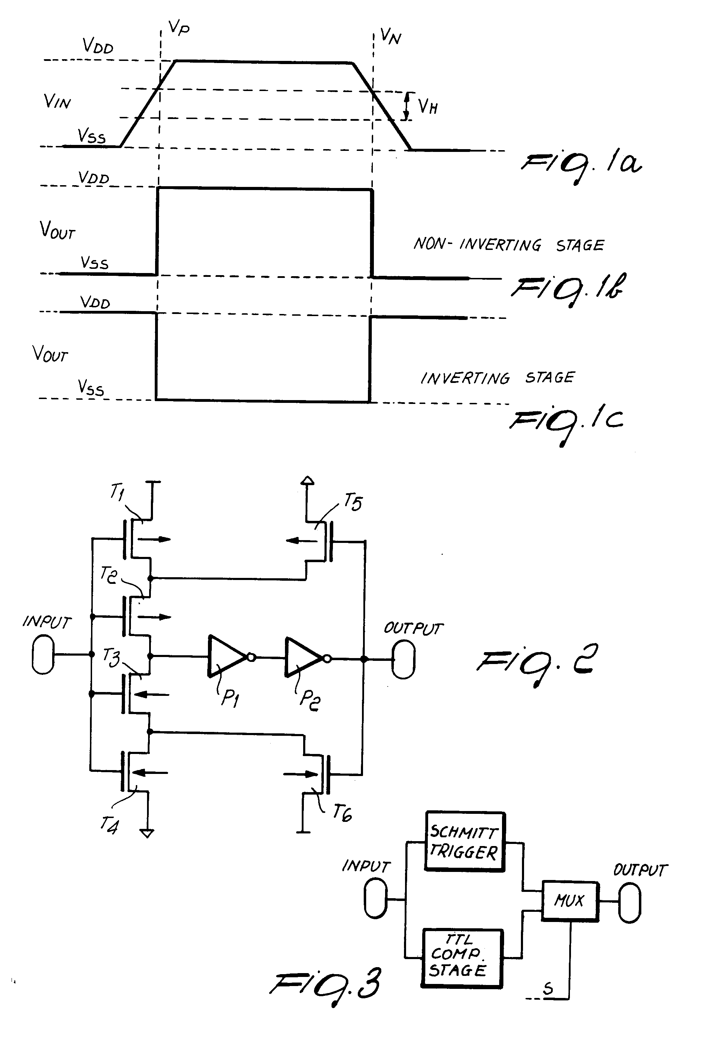

With reference to figures 1a, 1b and 1c, a Schmitt trigger, for example of the type illustrated in figure 2, has two different toggle threshold values, indicated respectively by $V_P$ and $V_N$, which are comprised between a minimum voltage $V_{SS}$ and a maximum voltage $V_{DD}$; as more clearly illustrated in said figures, said values intervene so as to modify the signal in output from the non-inverting stage, figure 1b, and the output signal of the inverting stage, figure 1c, for different values of the respectively rising and falling ramps of the signal, illustrated in figure 1a, which is applied to the input of said Schmitt trigger. The value of the intrinsic hysteresis of the Schmitt trigger is equal to the difference between the two threshold values $V_P$ and $V_N$ and is usually termed $V_H$.

A largely widespread example of circuital configuration in CMOS technology for the execution of a Schmitt trigger is the one provided in figure 2. Said example has an input terminal A, which is connected to the gate terminals of a first transistor $T_1$ and of a second transistor $T_2$, both of the P-channel type, and to the gate terminals of a third transistor $T_3$ and of a fourth transistor $T_4$, both of the N-channel type. The source terminal of the first transistor $T_1$ is connected to a power supply. The drain terminal of the first transistor $T_1$ is connected to the source terminal of the second transistor $T_2$ and to the drain terminal of a fifth P-channel transistor $T_5$. The drain terminal of the second transistor $T_2$ is connected to the drain terminal of the third transistor $T_3$ and to the input terminal of a first inverting gate $P_1$. The source terminal of the third transistor $T_3$ is connected to the drain terminal of the fourth transistor $T_4$ and to the drain terminal of a sixth N-channel transistor $T_6$. The source terminal of the fourth transistor $T_4$ is connected to the ground, and so is the source terminal of the fifth transistor $T_5$. The source terminal of the sixth transistor $T_6$ is connected to a power supply, whereas the gate terminals of the fifth transistor $T_5$ and of the sixth transistor $T_6$ are connected to the output terminal of another second inverting gate $P_2$ and to the output terminal of the Schmitt trigger B. Finally, the output terminal of the first inverting gate $P_1$ is connected to the input terminal of the second inverting gate $P_2$.

The described configuration prevents the insertion of compatibility with TTL circuitries. If it is necessary to provide both of the above described compatibilities, it is currently necessary to place next to the above described Schmitt trigger a separate circuit which has TTL compatibility. The two circuits, the Schmitt trigger and the TTL-compatible circuit, would have a common input and a separate output, as more clearly illustrated in figure 3. The differentiated outputs of said circuits must then be selected, and this requires the use of a further circuit which provides a selection function, such as for example a multiplexer, which by means of a selection command S would allow to select said two outputs.

The described solution entails an intolerable excessive occupation of silicon substrate, causes an increase in the input capacitance of the circuit, thus reducing the response speed performance of said circuit, and finally, quite unpleasantly, increases the power dissipation of said circuits, since alternatively one of two circuits is not used to process the signal applied to the input.

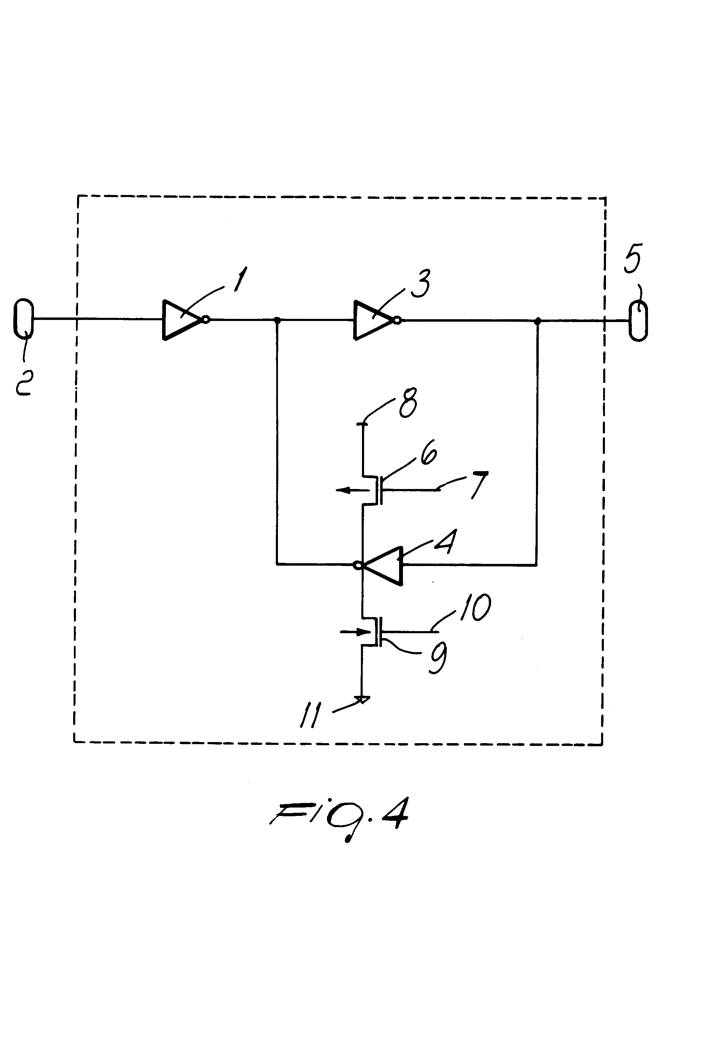

With reference to figure 4, a multi-compatible input stage particularly for logic gates in integrated circuits, according to the invention, comprises a first inverting logic gate 1 the input terminal whereof is connected to an input signal 2 for the input stage.

The output terminal of the first inverting logic gate 1 is connected to the input terminal of a second inverting logic gate 3 and to the output terminal of a third inverting logic gate 4.

The output terminal of the second inverting logic gate 3 is connected to the input terminal of the third inverting logic gate 4 and to the output terminal 5 of the input stage.

A first terminal and a second terminal are furthermore provided for selection signals of the third inverting logic gate.

The first terminal for selection signals of the third inverting logic gate 4 comprises a first P-channel transistor 6 which has a first negated logic selection signal 7 on its gate terminal. The first transistor 6 furthermore has its source terminal connected to a power supply 8 and its drain terminal connected to the source terminal of a P-channel transistor of the third inverting logic gate 4.

The second terminal for selection signals of the third inverting logic gate 4 comprises a second N-channel transistor 9 which has a second logic selection signal 10 on its gate terminal. The second transistor 9 has its source terminal connected to the ground 11 and its drain terminal connected to the source terminal of an N-channel transistor of the third inverting logic gate 4.

The second inverting logic gate 3 and the third inverting logic gate 4, together with their electrical connections, define a toggle circuit or Schmitt trigger. The second logic selection signal 10 selects the configuration of the input stage according to the invention as a Schmitt trigger.

The first inverting logic gate 1 defines a TTL (Transistor Transistor Logic) compatibility stage. The first negated logic selection signal 7 selects the configuration of the input stage according to the invention as a TTL-compatible stage.

The logic selection signals 7 and 10 are not mutually independent, but are mutually correlated by logic negation. When the logic selection signal 10 has a high logic value, the negated logic selection signal 7 in fact has a low logic value and vice versa. Thus, the configuration of the input stage according to the invention is changed by means of said selection signals 7 and 10. Said selection signals can be either taken from the integrated circuit in which the input stage according to the invention is integrated or can be transmitted to the integrated circuit by means of a further terminal for input to said integrated circuit, and in either of the two described cases they are transmitted to the respective gate terminals of the first transistor 6 and of the second transistor 9.

As can be deduced from what has been described above, the input stage according to the invention thus achieves the intended aim and objects. It furthermore allows easy integration on integrated electronic circuits with a considerable saving of silicon surface with respect to the currently known solutions, furthermore allowing to adapt the integrated circuit in which said stage is placed to different circuitries arranged in input to said integrated circuit.

In case of selection of the input stage as Schmitt trigger, the values of the toggle thresholds $V_P$ and $V_N$ are defined by the ratio of the values of the geometric gains, defined as K, assumed by the respective P-channel and N-channel MOSFET transistors which belong to the first inverting logic gate 1 and to the third inverting logic gate 4. For particular values of K, the hysteresis ratio is furthermore advantageously independent of the threshold voltages of the transistors used to define the input stage according to the invention. Finally, conveniently, the input stage according to the invention has high temperature stability, since said stability depends on the sum of the toggle thresholds $V_P$ and $V_N$ and on the ratio K.

The input stage according to the invention can be integrated in integrated circuits with Si-gate and Metal-gate C-MOS technologies, and it is possible to execute it either as an independent component which can be inserted in complex circuitries or as a portion of integrated circuits, as previously mentioned.

The invention thus conceived is susceptible to numerous modifications and variations, all of which are within the scope of the inventive concept. All the details may furthermore be replaced with other technically equivalent elements.

In practice, the materials employed, as well as the dimensions, may be any according to the requirements.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1. Multi-compatible input stage particularly for logic gates in integrated circuits, characterized in that it comprises a first inverting logic gate which has a respective input terminal which can be connected to an input signal for said input stage, said first inverting logic gate having its output terminal connected to the input terminal of a second inverting logic gate and to the output terminal of a third inverting logic gate, said second inverting logic gate having its output terminal connected to the input terminal of said third inverting logic gate and to the output terminal of said input stage, a first terminal and a second terminal being provided for selection signals of said third inverting logic gate.

2. Input stage according to claim 1, characterized in that said first terminal for selection signals of said third inverting logic gate comprises a first P-channel transistor which has a first logic selection signal on the gate terminal, its source terminal connected to a power supply and its drain terminal connected to the source terminal of a P-channel transistor of said third inverting logic gate.

3. Input stage according to claim 1, characterized in that said second terminal for selection signals of said third inverting logic gate comprises a second N-channel transistor which has a second logic selection signal on its gate terminal, its source terminal connected to the ground and its drain terminal connected to the source terminal of an N-channel transistor of said third inverting logic gate.

4. Input stage according to one or more of the preceding claims, characterized in that said second inverting logic gate and said third inverting logic gate define a Schmitt toggle circuit, said second logic selection signal being suitable for selecting said Schmitt toggle circuit.

5. Input stage according to one or more of the preceding claims, characterized in that said first inverting logic gate defines a TTL (Transistor Transistor Logic) compatible stage, said first logic selection signal being suitable for selecting said TTL-compatible stage.

Fig. 1a

NON-INVERTING STAGE

Fig. 1b

INVERTING STAGE

Fig. 1c

Fig. 2

Fig. 3

Fig. 4